# DEMANDE DE BREVET EUROPEEN

(11) **EP 0 993 244 A1**
(43) Date de publication de la demande: **12.04.2000**
(21) Numéro de dépôt: 99203164.1
(22) Date de dépôt: 28.09.1999
(51) Int. Cl.: H05K 9/00

(54) **Ecran de blindage électromagnétique et substrat support de circuit équipé d'un tel écran**

(30) Priorité: 06.10.1998 FR 9812496
(71) Demandeur: Koninklijke Philips Electronics N.V., 5621 BA Eindhoven (NL)
(72) Inventeur: Flegeo, Arnaud, 75008 Paris (FR)
(74) Mandataire: Pyronnet, Jacques

(57) **Abrégé**

L'écran de blindage électromagnétique est destiné à au moins un circuit électronique (12) monté sur un substrat (11), comprenant des faces latérales dite verticales formant une ceinture (2) et une face supérieure (3) dont les bords coïncident avec les bords supérieurs desdites faces latérales verticales, la ceinture et la face supérieure étant réalisées au moins en partie en un matériau électriquement conducteur et formant un sous-ensemble prévu pour être appliqué contre le substrat support (11) du circuit (13) à blinder. Selon l'invention, la ceinture (2) est de forme légèrement pyramidale, les faces latérales faisant un angle compris entre 92 degrés et 94 degrés par rapport à la face supérieure et la face supérieure comporte une prédécoupe (6) parallèlement et à proximité immédiate de ses bords.

Application aux téléphones sans fil et aux téléphones mobiles.

## Description

La présente invention concerne un écran de blindage électromagnétique pour au moins un circuit électronique monté sur un substrat, comprenant des faces latérales dites verticales formant une ceinture et une face dite supérieure dont les bords coïncident avec les bords supérieurs desdites faces latérales verticales, la ceinture et la face supérieure étant réalisées au moins en partie en un matériau électriquement conducteur et formant un sous-ensemble prévu pour être appliqué contre le substrat support du circuit à blinder.

Des appareils fonctionnant à haute fréquence tels que des téléphones sans fil (dits résidentiels) ou des téléphones mobiles (dits cellulaires) doivent comporter des écrans de blindage pour les composants (circuits électroniques) rayonnant en haute fréquence, de façon à éviter, pour ces derniers, des influences électromagnétiques perturbatrices. Une structure connue d'un tel écran de blindage consiste souvent en une ceinture et un couvercle coiffant celle-ci, qui forment l'un avec l'autre un sous-ensemble prévu pour être appliqué contre la carte de circuit imprimé (ou autre support du circuit à blinder tel qu'un substrat en céramique pour circuit hybride par exemple). Ce sous-ensemble est réalisé au moins en partie en un matériau électriquement conducteur afin de réaliser, pour la protection du circuit, une sorte de Cage de Faraday. La réalisation du blindage en deux pièces distinctes permet éventuellement d'avoir accès aux circuits protégés, pour réparation notamment, par ouverture du couvercle.

Les modes de liaison habituellement rencontrés pour la fixation du couvercle sur la ceinture sont la soudure, auquel cas la liaison est irréversible (ou, du moins, implique des manipulations matérielles assez lourdes), ou bien il est utilisé des solutions du genre lames ou rebords formant ressort et venant s'accrocher sur la ceinture. Ce genre de liaison est cette fois facilement démontable, mais les essais effectués montrent que des secousses ou des chocs exercés sur des structures ainsi réalisées conduisent souvent à l'ouverture intempestive du couvercle. De plus, le fait d'avoir deux pièces à fabriquer et à gérer ensuite, au niveau du stockage et de la mise en place sur le substrat support, entraîne un surcoût par rapport à un écran de blindage qui serait constitué d'une seule pièce, cet aspect de la chose prenant toute se valeur pour du matériel grand public -comme c'est essentiellement le cas visé ici- dont le prix doit être le plus bas possible.

De la demande de brevet Japonais JP-A-06 338695 il est connu un écran de blindage électromagnétique dont la face supérieure est prédécoupée selon une ligne fermée de trous formant pointillés, afin de pouvoir arracher cette face supérieure lorsqu'un composant sous-jacent doit être remplacé. Cependant une pièce spécifique doit être prévue pour refermer l'écran après réparation, cette pièce nouvelle pouvant être clipsée ou soudée à la ceinture restante, avec les inconvénients précités décrits ci-dessus lorsque l'écran de blindage se compose d'une ceinture et d'un couvercle.

Un but de l'invention est de réaliser un écran de blindage électromagnétique qui soit fait d'une seule pièce tout en permettant une réparation facile des composants électroniques qu'il protège.

Un autre but de l'invention est de réaliser un écran de blindage électromagnétique résistant aux chocs et de faible coût.

Ces buts sont atteints et les inconvénients de l'art antérieur sont atténués grâce au fait que l'écran de blindage électromagnétique indiqué au premier paragraphe est remarquable en ce que ladite ceinture est de forme légèrement pyramidale, lesdites faces latérales faisant un angle compris entre 92 degrés et 94 degrés par rapport à ladite face supérieure et que ladite face supérieure comporte une prédécoupe parallèlement et à proximité immédiate de ses bords.

L'écran de blindage est réalisé de préférence en tôle d'acier emboutie et la prédécoupe de la face supérieure peut être réalisée soit par une succession de trous rapprochés soit, de préférence, par cisaillement partiel de la partie centrale de la face supérieure, l'une ou l'autre opération étant réalisée lors de l'emboutissage de la tôle qui donne sa forme à l'écran. Pour la réparation d'un circuit enfermé par l'écran, il suffit d'arracher, par tout moyen connu la partie centrale prédécoupée, d'effectuer la réparation puis de reprendre un nouvel écran identique à celui d'origine et de l'emboutir à force sur ce qu'il reste de l'écran d'origine, c'est-à-dire la ceinture latérale, la mise en place par coincement étant assurée par les fortes pentes des faces qui constituent la ceinture.

La description qui suit en regard des dessins annexés, le tout donné à titre d'exemple non limitatif, fera bien comprendre comment l'invention peut être réalisée et mise en oeuvre.
La figure 1 est une vue latérale de l'écran de blindage selon l'invention.
La figure 2 est une vue de dessus de l'écran de blindage de la figure 1.
La figure 3 représente en coupe latérale un premier écran de blindage selon l'invention, monté sur une carte de circuit imprimé ou un support céramique.
La figure 4 représente en coupe latérale un deuxième écran de blindage combiné selon l'invention, monté sur une carte de circuit imprimé ou un support céramique.

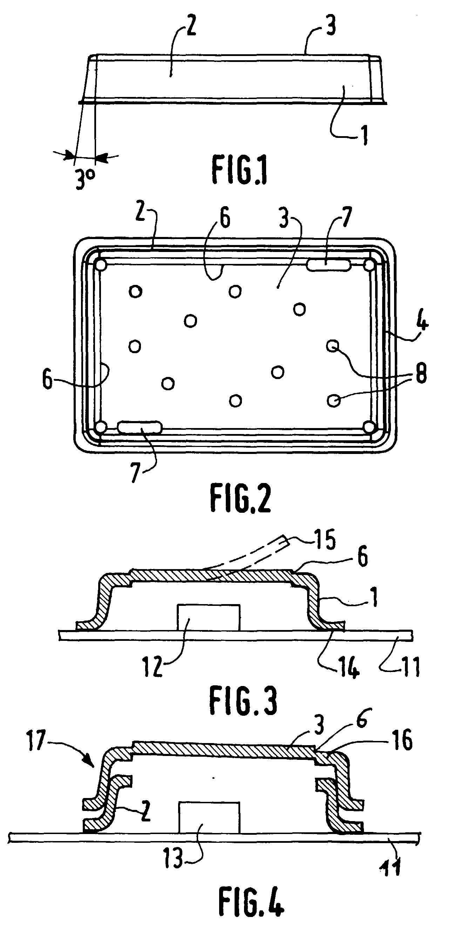

Les structures d'écrans de blindage représentées sur les figures 1 à 4 sont volontairement agrandies, afin de mieux montrer les détails, par rapport à ce qu'elles sont pour leur application typique qui est celle des téléphones mobiles et des téléphones sans fil étant entendu que, pour cette dernière application, de tels écrans sont présents aussi bien dans les combinés que dans la base.

La structure d'écran des figures 1 et 2 consiste en 4 faces latérales telles que 1 constituant une ceinture 2 ayant une section horizontale de forme rectangulaire à coins arrondis, et une face supérieure 3 dont les bords 4 coïncident avec les bords supérieurs des faces latérales. L'écran est réalisé en un matériau électriquement conducteur de préférence en acier. Comme acier, on peut utiliser par exemple du C1T-50 E4/E4 étamé, d'épaisseur 0,2 ± 0,05 mm. Selon l'invention, la ceinture 2 est de forme légèrement pyramidale, les 4 faces latérales telles que 1 faisant un angle compris entre 92 et 94 degrés par rapport à la face supérieure 3, et la face supérieure 3 comporte une prédécoupe 6 parallèlement et à proximité immédiate de ses bords 4. De préférence les faces latérales 1 forment un angle compris entre 92 degrés 50 minutes d'arc et 93 degrés 20 minutes d'arc par rapport à la face supérieure 3. La prédécoupe 6 peut être obtenue par cisaillement partiel de la partie centrale de la face supérieure 3, par emboutissage, comme il est visible sur la figure 3; de façon non représentée, elle pourraît aussi consister en des trous rapprochés le long de la ligne fermée 6, aussi obtenus par emboutissage de la tôle. De préférence, au moins un trou (oblong) 7, d'un diamètre de 1 à quelques millimètres, est pratiqué, par emboutissage, sur la prédécoupe 6 à travers la face supérieure. Ceci permet, avec un outil adéquat ou avec l'ongle, d'arracher l'essentiel de la face supérieure, si nécessaire. De préférence, la face supérieure 3 comporte plusieurs trous tels que 8. Ceci facilite l'opération de refusion dans la technique CMS (Composants pour Montage en Surface). Cette technique connue consiste précisément à déposer par sérigraphie une pâte à souder sur des plages de contact d'un circuit imprimé ou céramique en vue de la soudure ultérieure de composants selon un procédé de refusion, la pâte à souder qui constitue le produit de sérigraphie étant constituée par exemple de petites billes en un alliage de Pb-Sn de quelques microns de diamètre, agglomérées au moyen d'un liant qui confère à cette pâte des qualités thixotropiques. En l'occurrence, l'écran de blindage est fixé à son support au même titre et de la même façon que les autres composants. Cependant, lors de l'opération de refusion, il constitue, de façon parasite, un écran thermique vis-à-vis des composants qu'il recouvre; les trous 8 permettent d'atténuer la différence de température (de l'ordre de 10 degrés aux environs de 240 degrés) qui existe entre l'intérieur et l'extérieur de l'écran de blindage, lors de l'opération de refusion ; ces trous ne sont cependant pas indispensables, moyennant que la tôle qui constitue l'écran soit assez mince, ce qui est généralement le cas (0,15 ou 0,2 mm d'épaisseur). Lorsque l'écran comporte des trous tels que 7 et 8, le diamètre de ces trous doit être assez faible pour ne pas nuire à l'effet de "Cage de Faraday" que vise à constituer l'écran. De façon plus ou moins empirique, le diamètre des trous est choisi inférieur à un vingtième de la longueur d'onde du rayonnement électromagnétique des composants à protéger. Pour un combiné de téléphone sans fil ou sa base, ceci résulte en des trous ayant un diamètre de l'ordre de un à quelques mm (fréquences de l'ordre de 2 GHz). De préférence, l'écran de blindage représenté sur les figures 1 et 2 est fabriqué en une seule opération d'emboutissage qui lui donne sa forme, et réalise la prédécoupe 6 et les trous éventuels 7 et 8. L'écran de blindage est généralement monté sur une carte de circuit imprimé par exemple en verre époxy ou un support céramique (en 11, figures 3 et 4). De préférence, pour éviter des contraintes mécaniques indésirables entre l'écran et son support après l'opération de refusion, on choisit les matériaux qui constituent l'écran et son support tels qu'ils aient sensiblement le même coefficient de dilatation.

Les figures 3 et 4 montrent comment peut s'effectuer une réparation, c'est-à-dire le remplacement d'un composant défectueux 12 (figure 3) par un nouveau composant 13 (figure 4). Pour ce faire, l'écran de blindage étant soudé par ses bords inférieurs 14 à une piste métallique du substrat support 11, on arrache et on jette la partie centrale de sa face supérieure comme représenté en trait interrompu 15 à la figure 3, l'arrachement s'effectuant au niveau de la prédécoupe 6. Ensuite, le circuit électronique est dessoudé, retiré et remplacé par le circuit neuf 13; puis, un nouvel écran 16 semblable ou identique à celui (d'origine) représenté sur la figure 1 est emboîté à force sur ce qu'il reste de récran d'origine, c'est-à-dire la ceinture latérale 2, la mise en place par coincement étant assurée par les fortes pentes des faces qui constituent la ceinture 2. Il en résulte un nouvel écran de blindage combiné 17, constitué par l'assemblage des éléments 2 et 16, et surélevé de 1 à 2 mm par rapport à l'écran d'origine, pour un écran dont la hauteur est égale à 4 mm environ, lequel écran combiné satisfait bien aux tests habituels en la matière pour des combinés de téléphone mobile ou sans fil, les tests de vibrations notamment et les tests de chocs consécutifs à des chutes. Le coincement de l'écran 16 sur la ceinture 2 peut se faire manuellement, en appuyant aux 4 coins simultanément de préférence ou au moyen d'un outil plus ou moins spécifique qu'il est facile à l'homme du métier de concevoir (un outil comportant un méplat par exemple à presser contre la face supérieure de l'écran 16). S'il devait s'avérer nécessaire de remplacer à son tour le circuit 13 par un nouveau, il est possible de recommencer les opérations permettant de passer de l'écran de la figure 3 à celui, combiné, de la figure 4; cependant il est préférable de désolidariser les parties 2 et 16 avec l'ongle ou un tournevis et de jeter le blindage 16 qui risque d'être gauchi, ce qui nous ramène à l'étape de la séparation antérieure où l'on venait d'arracher et de jeter la partie centrale de la face supérieure 3 du premier écran de blindage solidaire du support 11.

L'invention permet ainsi de réaliser un écran de blindage, en une seule opération d'emboutissage d'une seule pièce, à posage automatique, et qui permet de façon simple la réparation de composant(s) sous-jacent(s), moyennant un coût environ moitié par rapport aux écrans de l'art connu.

Outre fa téléphonie mobile et résidentielle, l'invention peut s'appliquer à des émetteurs et/ou récepteurs radio à haute fréquence, au DAB (Digital Audio Broadcasting en anglais) notamment.

## Revendications

1. Ecran de blindage électromagnétique pour au moins un circuit électronique monté sur un substrat, comprenant des faces latérales dites verticales formant une ceinture et une face dite supérieure dont les bords coïncident avec les bords supérieurs desdites faces latérales verticales, la ceinture et la face supérieure étant réalisées au moins en partie en un matériau électriquement conducteur et formant un sous-ensemble prévu pour être appliqué contre le substrat support du circuit à blinder, caractérisé en ce que ladite ceinture est de forme légèrement pyramidale, lesdites faces latérales faisant un angle compris entre 92 degrés et 94 degrés par rapport à ladite face supérieure et que ladite face supérieure comporte une prédécoupe parallèlement et à proximité immédiate de ses bords.

2. Ecran de blindage électromagnétique selon la revendication 1, caractérisé en ce que lesdites faces latérales font un angle compris entre 92 degrés 50 minutes d'arc et 93 degrés 20 minutes d'arc par rapport a ladite face supérieure.

3. Ecran de blindage électromagnétique selon la revendication 1 ou 2, caractérisé en ce qu'il comporte au moins un trou d'un diamètre de l'ordre de un à quelques millimètres, disposé le long de ladite prédécoupe à travers ladite face supérieure.

4. Ecran de blindage selon la revendication 3, caractérisé en ce qu'il comporte plusieurs trous de diamètre de l'ordre de un à quelques millimètres, disposés à travers ladite face supérieure.

5. Ecran de blindage selon l'une des revendications 1 à 4, caractérisé en ce qu'il est réalisé en acier embouti, en une seule opération d'emboutissage.

6. Ecran de blindage selon l'une des revendications 1 à 5, caractérisé en ce qu'il a été monté sur ledit substrat autour et au-dessus dudit circuit électronique et en même temps que ce dernier par refusion d'une pâte de soudure selon la technique dite CMS - Composants pour Montage en Surface.

7. Ecran de blindage selon l'une des revendications 1 à 6, caractérisé en ce qu'il est réalisé en un acier dont le coefficient de dilatation est sensiblement égal à celui dudit substrat.

8. Procédé de remplacement d'un circuit électronique défectueux protégé par un écran de blindage d'origine selon l'une des revendications 1 à 7, caractérisé en ce qu'il comporte les étapes suivantes:
- l'arrachement de ladite face supérieure de l'écran d'origine au niveau de ladite prédécoupe;
- le remplacement dudit circuit électronique défectueux par un autre circuit électronique en état de fonctionner;
- le recouvrement avec effet de coincement par pression de ladite ceinture de l'écran de blindage d'origine par un autre écran de blindage selon l'une des revendications 1 à 7.

9. Ecran de blindage électromagnétique obtenu par le procédé selon la revendication 8.

10. Carte de circuit imprimé ou autre support similaire constituant un substrat pour au moins un circuit électronique, caractérisé(e) en ce qu'il(elle) est équipé(e), pour la protection dudit circuit, d'au moins un écran de blindage électromagnétique selon l'une des revendications 1 à 7 ou 9.
